# EUROPEAN PATENT APPLICATION

(11) **EP 4 571 832 A1**
(43) Date of publication of application: **18.06.2025**
(21) Application number: 23852982.0
(22) Date of filing: 09.08.2023
(51) Int. Cl.: H01L 23/498, H01L 23/00, H01L 23/15, H05K 1/18, H05K 1/11

(54) **CIRCUIT BOARD AND SEMICONDUCTOR PACKAGE COMPRISING SAME**

(30) Priority: 09.08.2022 KR 20220099216
(71) Applicant: LG INNOTEK CO., LTD., Seoul 07796 (KR)
(72) Inventor: HEO, Seong Ho, Seoul 07796 (KR); KIM, Sung Min, Seoul 07796 (KR)
(74) Representative: Plasseraud IP
(86) International application number: PCT/KR2023/011746
(87) International publication number: WO 2024/035111

(57) **Abstract**

A circuit board according to an embodiment includes an insulating layer; and, an electrode part disposed in the insulating layer, wherein the electrode part includes: a first electrode; a second electrode disposed on the first electrode; and first and second via electrodes disposed between the first electrode and the second electrode, the first via electrode is connected to the first electrode and the second electrode, and a length of the second via electrode in a vertical direction is smaller than a length of the first via electrode in the vertical direction.

## Description

### [Technical Field]

An embodiment relates to a circuit board, and more particularly, to a circuit board having improved adhesion between an insulating layer and an electrode part and a semiconductor package including the same.

### [Background Art]

As performances of electric/electronic products progresses, technologies for disposing a greater number of semiconductor devices on a semiconductor package substrate of a limited size are being proposed and studied. However, since a general semiconductor package is based on mounting a single semiconductor device, there is a limit to obtaining a desired performance.

Accordingly, a semiconductor package that mounts a plurality of semiconductor devices using a plurality of circuit boards has been recently provided. This semiconductor package has a structure in which a plurality of semiconductor devices are connected to each other in a horizontal direction and/or a vertical direction on the circuit board. Accordingly, the semiconductor package has the advantage of efficiently using a mounting area of the semiconductor devices and transmitting highspeed signals through a short signal transmission path between the semiconductor devices.

Due to these advantages, the semiconductor package as described above is widely applied to mobile devices, etc.

In addition, semiconductor packages applied to products that provide the Internet of Things (IoT), autonomous vehicles, and high-performance servers are expanding a concept to semiconductor chiplets as a number of semiconductor devices and/or a size of each semiconductor device increases in accordance with a trend of high integration, or as functional parts of the semiconductor devices are divided.

Accordingly, an intercommunication between semiconductor devices and/or semiconductor chiplets is becoming important, and accordingly, there is a trend to dispose an interposer between the circuit board of the semiconductor package and the semiconductor devices.

An interposer can function as a redistribution layer that gradually increases a width or depth of a circuit pattern from the semiconductor device to the semiconductor package in order to facilitate the intercommunication between the semiconductor devices and/or semiconductor chiplets, or to interconnect the semiconductor devices and the semiconductor package substrate, thereby smoothly transmitting electrical signals between the semiconductor device and the semiconductor package substrate having a relatively large circuit pattern compared to the circuit pattern of the semiconductor device.

An interposer may have an area greater than a total area of a plurality of semiconductor devices and/or semiconductor chiplets in order to mount a plurality of semiconductor devices and/or semiconductor chiplets as a whole, or may be disposed only in a portion for interconnection between the semiconductor devices and/or semiconductor chiplets. That is, an area of the interposer may increase as the number of semiconductor devices and/or semiconductor chiplets increases, or an area of the interposer may not increase. However, as the number of semiconductor devices and/or semiconductor chiplets increases, an area of a circuit board of the semiconductor package tends to increase.

Accordingly, as an area of the semiconductor package increases, tan area of the electrode part also increases. At this time, when the area of the electrode part increases, a problem may occur in which gas generated from the insulating layer in contact with the electrode part is not sufficiently discharged. In addition, when the gas is not discharged, a problem may occur in which a surface of the electrode part swells due to the gas, and as a result, a problem may occur in which the electrode part is peeled off from the insulating layer.

Meanwhile, in order to solve the problems, the electrode part of a conventional technology may be provided with a through hole corresponding to a gas outlet for discharging the gas. However, when the through hole is provided in the electrode part, an area of the electrode part decreases due to the through hole, and there is a problem in which a rigidity of the semiconductor package decreases due to the decrease in the area of the electrode part. In addition, when the rigidity decreases, a problem in which the semiconductor package is greatly bent in a specific direction may occur. In addition, the electrode part of the semiconductor package may include an impedance matching part that performs an impedance matching function, etc. At this time, the impedance matching part and/or the electrode part vertically or horizontally adjacent to the impedance matching unit may not be provided with a through hole corresponding to the gas outlet. For example, if the impedance matching part and/or the electrode part adjacent to the impedance matching part is provided with a through hole, impedance matching characteristics may be changed due to the through hole, and accordingly, electrical characteristics of the semiconductor package may be deteriorated.

### [Disclosure]

### [Technical Problem]

The embodiment provides a circuit board having a novel structure and a semiconductor package including the same.

In addition, the embodiment provides a circuit board having improved adhesion between an insulating layer and an electrode part and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises an insulating layer; and, an electrode part disposed in the insulating layer, wherein the electrode part includes a first electrode; a second electrode disposed on the first electrode; and first and second via electrodes disposed between the first electrode and the second electrode, wherein the first via electrode is connected to the first electrode and the second electrode, and a length of the second via electrode in a vertical direction is smaller than a length of the first via electrode in the vertical direction.

In addition, the second via electrode is connected to the second electrode.

In addition, the second via electrode is spaced apart from the first via electrode in a horizontal direction.

In addition, the second via electrode extends from the second electrode toward the first electrode.

In addition, an upper surface of the second via electrode is positioned on a same plane as an upper surface of the first via electrode, and a lower surface of the second via electrode is positioned higher than a lower surface of the first via electrode.

In addition, the length of the second via electrode in the vertical direction satisfies a range of 30% to 70% of the length of the first via electrode in the vertical direction.

In addition, a width of the second via electrode in a horizontal direction is smaller than a width of the first via electrode in the horizontal direction.

In addition, the second via electrode has a slope whose width in the horizontal direction gradually changes as the second via electrode moves away from the second electrode.

In addition, the first via electrode has a slope whose width in the horizontal direction gradually changes from the second electrode toward the first electrode.

In addition, the slope of the second via electrode is same as the slope of the first via electrode.

In addition, the first via electrode includes a first portion that overlaps the second via electrode within the insulating layer in the horizontal direction, and a second portion that does not overlap the second via electrode in the horizontal direction.

Meanwhile, a semiconductor package according to an embodiment includes the circuit board, and a connection part disposed on a second electrode on the circuit board.

In addition, the second via electrode extends from the second electrode and is disposed within the insulating layer, and the second electrode further includes a bonding part that extends outside the insulating layer and does not overlap the insulating layer in the horizontal direction, and the connection part is disposed on the bonding part.

In addition, the bonding part extends from the second electrode in a direction opposite to a direction in which the second via electrode extends.

In addition, the semiconductor package includes an interposer disposed on the connection part, and the interposer includes at least one of an active interposer and a passive interposer.

In addition, the semiconductor package further includes a semiconductor device disposed on the connection part.

### [Advantageous Effects]

The circuit board of the embodiment may include an insulating layer; and an electrode part disposed in the insulating layer. In addition, the electrode part may include a first electrode; a second electrode disposed on the first electrode; and a first via electrode connecting the first electrode and the second electrode along a vertical direction. In addition, the electrode part may include a second via electrode extending along a vertical direction, and a length of the second via electrode in a vertical direction may be smaller than a length of the first via electrode in a vertical direction. The second via electrode may extend from the second electrode in the vertical direction and thus function to improve adhesion between the insulating layer and the electrode part. For example, the second via electrode may function as an anchor to firmly fix the electrode part to the insulating layer. Accordingly, the embodiment may improve adhesion between the insulating layer and the electrode part. Therefore, the embodiment may solve a physical reliability problem in which the electrode part is peeled off from the insulating layer.

At this time, the insulating layer may generate gas during a curing process. In addition, if the gas is not completely removed to an outside of the insulating layer, a problem may occur in which the electrode part swells from the insulating layer due to the gas. To solve this problem, a through hole for gas discharge may be formed in the electrode part. However, if the through hole is provided in the electrode part, electrical characteristics (e.g., impedance characteristics) of the electrode part may change, and an electrical reliability problem may occur accordingly. In addition, if the through hole is provided in the electrode part, an area of the electrode part may decrease by an area of the through hole, and a rigidity of the circuit board and the semiconductor package may decrease accordingly. Accordingly, a problem in which the circuit board and the semiconductor package are greatly bent in a specific direction may occur.

In contrast, the embodiment provides a second via electrode in the electrode part, and thus, the rigidity of the circuit board and the semiconductor package may be maintained without changing the electrical characteristics of the electrode part, while improving the adhesion between the electrode part and the insulating layer. Therefore, the embodiment can improve overall product reliability of the circuit board and the semiconductor package.

In addition, as a number of input terminals and output terminals of semiconductor devices increases, a width and/or a spacing of terminals of semiconductor devices and/or semiconductor chiplets are narrowing. Accordingly, a width and/or spacing of electrodes provided in a circuit board are also becoming smaller. In addition, as the width and/or spacing of the electrodes becomes smaller, an contact area between the electrode part and the insulating layer decreases, which may cause a mechanical reliability problem in which the electrode part is easily peeled off from the insulating layer. Furthermore, in order to minimize the width and/or spacing of the electrodes, the insulating layer may include a photosensitive material. The photosensitive material may be, for example, a PID (Photo Imageable Dielectric). An insulating layer having a photosensitive material can be used to form electrodes using a photolithography process, and thus, it may be possible to fine the width and/or spacing of the electrodes. At this time, the photosensitive material has a characteristic of low adhesion to the electrode compared to a thermosetting material. Accordingly, the embodiment can solve a mechanical reliability problem of the electrode being peeled off from the insulating layer by using a protrusion provided in the electrode part when the width and/or spacing of the electrode is made fine, or when the insulating layer includes a photosensitive material, thereby improving overall product reliability of the circuit board and the semiconductor package.

Furthermore, a rigidity of the insulating layer provided with the photosensitive material may be lower than a rigidity of the thermosetting material provided with the reinforcing member. Accordingly, the circuit board provided with the photosensitive material has a problem of being greatly bent in a specific direction. At this time, the embodiment can improve the rigidity of the circuit board by using a protrusion provided in the electrode, thereby preventing the circuit board and the semiconductor package from being greatly bent in a specific direction.

### [Description of Drawings]

FIG. 1a is a cross-sectional view showing a semiconductor package according to a first embodiment.
FIG. 1b is a cross-sectional view showing a semiconductor package according to a second embodiment.
FIG. 1c is a cross-sectional view showing a semiconductor package according to a third embodiment.
FIG. 1d is a cross-sectional view showing a semiconductor package according to a fourth embodiment.
FIG. 1e is a cross-sectional view showing a semiconductor package according to a fifth embodiment.
FIG. 1f is a cross-sectional view showing a semiconductor package according to a sixth embodiment.
FIG. 1g is a cross-sectional view showing a semiconductor package according to a seventh embodiment.
FIG. 2a is a cross-sectional view showing a circuit board according to a first embodiment.
FIG. 2b is a cross-sectional view showing a circuit board according to a second embodiment.
FIG. 3 is a drawing for explaining a problem of a circuit board according to a prior art.
FIG. 4 is a cross-sectional view showing an arrangement structure of an electrode part according to a first embodiment.
FIG. 5 is a cross-sectional view showing an arrangement structure of an electrode part according to a second embodiment.
FIG. 6 is a cross-sectional view showing an arrangement structure of an electrode part according to a third embodiment.
FIG. 7 is a cross-sectional view showing an arrangement structure of an electrode part according to a fourth embodiment.
FIG. 8a is a plan view for explaining an arrangement structure of an electrode part according to an embodiment.
FIG. 8b is a cross-sectional view for explaining an arrangement structure of an electrode part according to an embodiment.
FIG. 9 is a cross-sectional view showing an arrangement structure of an electrode part according to a fourth embodiment.

### [Best Mode]

Hereinafter, exemplary embodiments of the present invention will be described in detail with reference to the accompanying drawings, wherein like reference numerals are used to designate identical or similar elements, and redundant description thereof will be omitted. The suffix "module" and "portion" of the components used in the following description are only given or mixed in consideration of ease of preparation of the description, and there is no meaning or role to be distinguished as it is from one another. Also, in the following description of the embodiments of the present invention, a detailed description of related arts will be omitted when it is determined that the gist of the embodiments disclosed herein may be obscured. Also, the accompanying drawings are included to provide a further understanding of the invention, are incorporated in, and constitute a part of this description, and it should be understood that the invention is intended to cover all modifications, equivalents, or alternatives falling within the spirit and scope of the invention.

Terms including ordinals, such as first, second, etc., may be used to describe various components, but the elements are not limited to these terms. The terms are used only for distinguishing one component from another.

When a component is referred to as being "connected" or "contacted" to another component, it may be directly connected or joined to the other component, but it should be understood that other component may be present therebetween. When a component is referred to as being "directly connected" or "directly contacted" to another component, it should be understood that other component may not be present therebetween.

A singular representation includes plural representations, unless the context clearly implies otherwise.

In the present application, terms such as "including" or "having" are used to specify the presence of features, numbers, steps, operations, components, parts, or combinations thereof described in the description. However, it should be understood that the terms do not preclude the presence or addition of one or more other features, numbers, steps, operations, components, parts, or combinations thereof.

Hereinafter, embodiments of a present invention will be described in detail with reference to attached drawings.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one semiconductor device. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (e.g., DRAM), non-volatile memory (e.g., ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

In addition, the circuit board in one embodiment may be a first circuit board described below.

In addition, the circuit board in another embodiment may be a second circuit board described below.

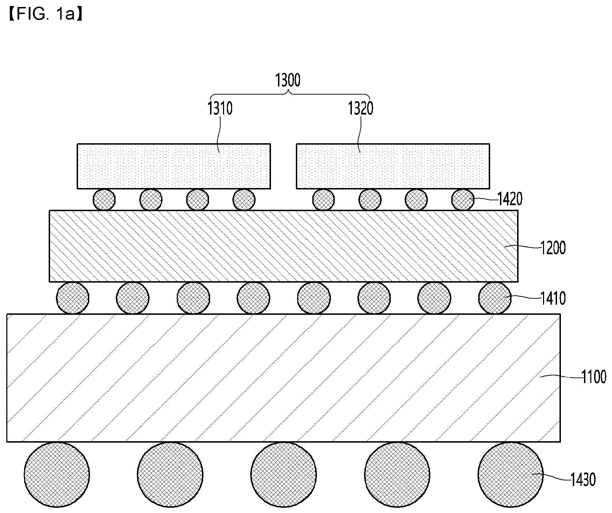

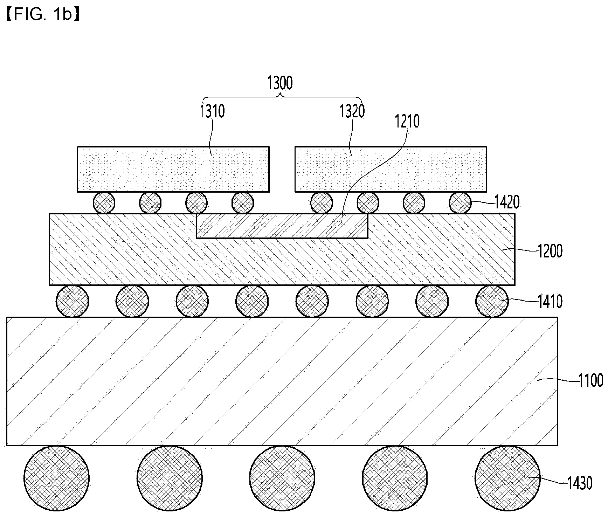

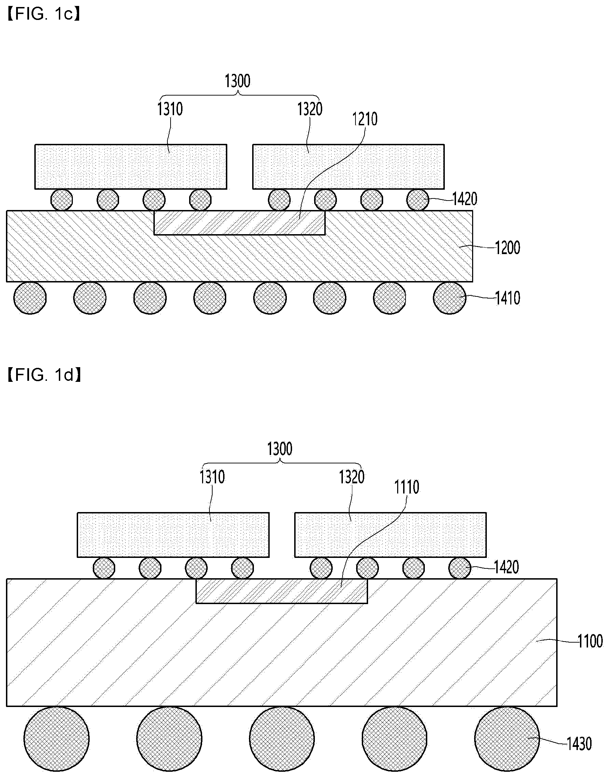

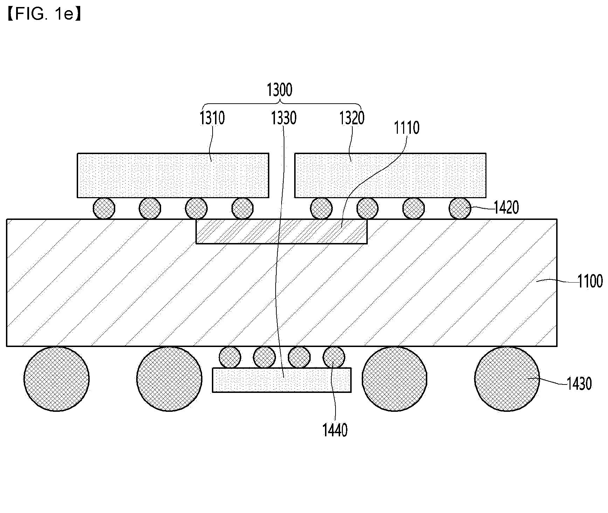

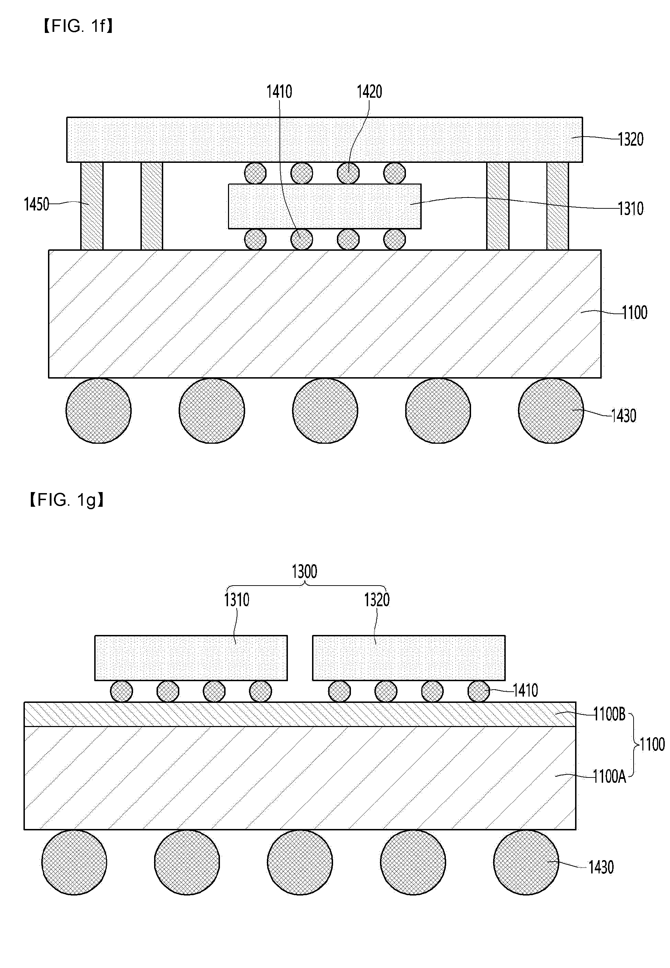

FIG. 1a is a cross-sectional view showing a semiconductor package according to a first embodiment, FIG. 1b is a cross-sectional view showing a semiconductor package according to a second embodiment, FIG. 1c is a cross-sectional view showing a semiconductor package according to a third embodiment, FIG. 1d is a cross-sectional view showing a semiconductor package according to a fourth embodiment, FIG. 1e is a cross-sectional view showing a semiconductor package according to a fifth embodiment, FIG. 1f is a cross-sectional view showing a semiconductor package according to a sixth embodiment, and FIG. 1g is a cross-sectional view showing a semiconductor package according to a seventh embodiment.

Referring to FIG. 1a, the semiconductor package according to the first embodiment may include a first circuit board 1100, a second circuit board 1200, and a semiconductor device 1300.

The first circuit board 1100 may mean a package substrate.

For example, the first circuit board 1100 may provide a space to which at least one external circuit board is coupled. The external circuit board may refer to a second circuit board 1200 coupled to the first circuit board 1100. Also, the external circuit board may refer to a main board included in an electronic device coupled to a lower portion of the first circuit board 1100.

Also, although not shown in the drawing, the first circuit board 1100 may provide a space in which at least one semiconductor device is mounted.

The first circuit board 1100 may include at least one insulating layer, an electrode part disposed on the at least one insulating layer.

A second circuit board 1200 may be disposed on the first circuit board 1100.

The second circuit board 1200 may be an interposer. For example, the second circuit board 1200 may provide a space in which at least one semiconductor device is mounted. The second circuit board 1200 may be connected to the at least one semiconductor device 1300. For example, the second circuit board 1200 may provide a space in which the first semiconductor device 1310 and the second semiconductor device 1320 are mounted. The second circuit board 1200 may electrically connect the first and second semiconductor devices 1310 and 1320 and the first circuit board 1100 while electrically connecting the first semiconductor device 1310 and the second semiconductor device 1320. That is, the second circuit board 1200 may perform a horizontal connection function between a plurality of semiconductor devices and a vertical connection function between the semiconductor devices and the package substrate.

FIG. 1a illustrates that the first and second semiconductor devices 1310 and 1320 are disposed on the second circuit board 1200, but is not limited thereto. For example, one semiconductor device may be disposed on the second circuit board 1200, or alternatively, three or more semiconductor devices may be disposed.

The second circuit board 1200 may be disposed between at least one semiconductor device 1300 and the first circuit board 1100.

In an embodiment, the second circuit board 1200 may be an active interposer that functions as a semiconductor device. When the second circuit board 1200 functions as a semiconductor device, the semiconductor package of the embodiment may have a structure that is vertically stacked on the first circuit board 1100 and may have functions of multiple logic chips. Having the function of a logic chip may mean that it may have functions of an active device and a passive device. In a case of an active device, characteristics of current and voltage may not be linear unlike a passive device, and in a case of an active interposer, it may have the function of an active device. In addition, the active interposer may perform a function of a corresponding logic chip while performing a signal transmission function between a second logic chip disposed thereon and the first circuit board 1100.

According to another embodiment, the second circuit board 1200 may be a passive interposer. For example, the second circuit board 1200 may function as a signal relay between the semiconductor device 1300 and the first circuit board 1100, and can have a passive device function such as a resistor, capacitor, or inductor. For example, a number of terminals of the semiconductor device 1300 is gradually increasing due to 5G, Internet of Things (IOT), increased image quality, and increased communication speed. That is, the number of terminals provided in the semiconductor device 1300 increases, thereby reducing the width of the terminals or an interval between the plurality of terminals. In this case, the first circuit board 1100 may be connected to the main board of the electronic device. There is a problem in that the thickness of the first circuit board 1100 increases or the layer structure of the first circuit board 1100 becomes complicated in order for the electrodes provided on the first circuit board 1100 to have a width and an interval to be respectively connected to the semiconductor device 1300 and the main board. Accordingly, in the first embodiment, the second circuit board 1200 may be disposed on the first circuit board 1100 and the semiconductor device 1300. In addition, the second circuit board 1200 may include electrodes having a fine width and an interval corresponding to the terminals of the semiconductor device 1300.

The semiconductor device 1300 may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far. The memory chip may be a stack memory such as HBM. The memory chip may also include a memory chip such as volatile memory (e.g., DRAM), non-volatile memory (e.g., ROM), flash memory, and the like.

Meanwhile, the semiconductor package of the first embodiment may include a connection part.

For example, the semiconductor package may include a first connection part 1410 disposed between the first circuit board 1100 and the second circuit board 1200. The first connection part 1410 may electrically connect the second circuit board 1200 to the first circuit board 1100 while coupling them.

For example, the semiconductor package may include the second connection part 1420 disposed between the second circuit board 1200 and the semiconductor device 1300. The second connection part 1420 may electrically connect the semiconductor device 1300 to the second circuit board 1200 while coupling them.

The semiconductor package may include a third connection part 1430 disposed on a lower surface of the first circuit board 1100. The third connection part 1430 may electrically connect the first circuit board 1100 to the main board while coupling them.

At this time, the first connection part 1410, the second connection part 1420, and the third connection part 1430 may electrically connect between the plurality of components by using at least one bonding method of wire bonding, solder bonding and metal-to-metal direct bonding. That is, since the first connection part 1410, the second connection part 1420, and the third connection part 1430 have a function of electrically connecting a plurality of components, when the metal-to-metal direct bonding is used, the connection part of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. In addition, to directly bond between the plurality of components. In addition, the metal-to-metal direct bonding method may refer to a bonding method by the second connection part 1420. In this case, the second connection part 1420 may mean a metal layer formed between a plurality of components by the recrystallization.

Specifically, the first connection part 1410, the second connection part 1420, and the third connection part 1430 may couple a plurality of components to each other by a thermal compression (TC) bonding method. The thermal compression bonding may refer to a method of directly coupling a plurality of components by applying heat and pressure to the first connection part 1410, the second connection part 1420, and the third connection part 1430.

At this time, at least one of the first circuit board 1100 and the second circuit board 1200 may be provided with a protrusion that protrudes outwardly away from the insulating layer of the corresponding board, on which the first connection part 1410, the second connection part 1420, and the third connection part 1430 are disposed. The protrusion may protrude outwardly from the first circuit board 1100 or the second circuit board 1200.

The protrusion may be referred to as a bump. The protrusion may also be referred to as a post. The protrusion may also be referred to as a pillar. Preferably, the protrusion may refer to an electrode on which a second connection part 1420 for coupling with the semiconductor device 1300 is disposed among the electrodes of the second circuit board 1200. That is, as the pitch of the terminals of the semiconductor device 1300 becomes finer, a short circuit may occur between the plurality of second connection parts 1420 that are respectively connected to the plurality of terminals of the semiconductor device 1300 by a conductive adhesive such as a solder. Therefore, in the embodiment, thermal compression bonding may be performed to reduce a volume of the second connection part 1420. In addition, in order to secure diffusion prevention and alignment to prevent an intermetallic compound (IMC) formed between a conductive adhesive such as solder and a protrusion from diffusing into the interposer and/or the circuit board, a protrusion may be included in the electrode of the second circuit board 1200 on which the second connection part 1420 is disposed.

Meanwhile, referring to FIG. 1b, the semiconductor package of the second embodiment may differ from the semiconductor package of the first embodiment in that the connection member 1210 is disposed on the second circuit board 1200. The connection member 1210 may be referred to as a bridge substrate. For example, the connection member 1210 may include a redistribution layer. The connection member 1210 may perform a function of electrically connecting a plurality of semiconductor devices horizontally to each other. For example, since the area that a semiconductor device should generally have been too large, the connection member 1210 may include a redistribution layer. Since the semiconductor package and the semiconductor device have a large difference in a width or spacing of the circuit pattern, etc., a buffering role of the circuit pattern for electrical connection is required. The buffering role may mean having a size between a width or spacing of the circuit pattern of the semiconductor package and a width or spacing of the circuit pattern of the semiconductor device, and the redistribution layer may include a function of performing the buffering role.

In an embodiment, the connection member 1210 may be a silicon bridge. That is, the connection member 1210 may include a silicon substrate and a redistribution layer disposed on the silicon substrate.

In another embodiment, the connection member 1210 may be an organic bridge. For example, the connection member 1210 may include an organic material. For example, the connection member 1210 may include an organic substrate including an organic material instead of the silicon substrate.

The connection member 1210 may be embedded in the second circuit board 1200, but is not limited thereto. For example, the connection member 1210 may be disposed on the second circuit board 1200 to have a protruding structure.

Also, the second circuit board 1200 may include a cavity, and the connection member 1210 may be disposed in the cavity of the second circuit board 1200.

The connection member 1210 may horizontally connect a plurality of semiconductor devices disposed on the second circuit board 1200.

Referring to FIG. 1c, the semiconductor package according to the third embodiment may include a second circuit board 1200 and a semiconductor device 1300. In this case, the semiconductor package of the third embodiment may have a structure in which the first circuit board 1100 is removed compared to the semiconductor package of the second embodiment.

That is, the second circuit board 1200 of the third embodiment may function as a package substrate while performing an interposer function.

The first connection part 1410 disposed on the lower surface of the second circuit board 1200 may couple the second circuit board 1200 to the main board of the electronic device.

Referring to FIG. 1d, the semiconductor package according to the fourth embodiment may include a first circuit board 1100 and a semiconductor device 1300.

In this case, the semiconductor package of the fourth embodiment may have a structure in which the second circuit board 1200 is omitted compared to the semiconductor package of the second embodiment.

That is, the first circuit board 1100 of the fourth embodiment can function as a package substrate while also performing the function of connecting the semiconductor device 1300 and a main board. To this end, the first circuit board 1100 may include a connection member 1110 for connecting the plurality of semiconductor devices. The connection member 1110 may be a silicon bridge or an organic material bridge connecting a plurality of semiconductor devices.

Referring to FIG. 1e, the semiconductor package of the fifth embodiment further may include a third semiconductor device 1330 compared to the semiconductor package of the fourth embodiment.

To this end, a fourth connection part 1440 may be disposed on the lower surface of the first circuit board 1100.

In addition, a third semiconductor device 1330 may be disposed on the fourth connection part1400. That is, the semiconductor package of the fifth embodiment may have a structure in which semiconductor devices are mounted on upper and lower sides, respectively.

In this case, the third semiconductor device 1330 may have a structure disposed on the lower surface of the second circuit board 1200 in the semiconductor package of FIG. 1c.

Referring to FIG. 1f, the semiconductor package according to the sixth embodiment may include a first circuit board 1100. A first semiconductor device 1310 may be disposed on the first circuit board 1100. To this end, a first connection part 1410 may be disposed between the first circuit board 1100 and the first semiconductor device 1310.

In addition, the first circuit board 1100 may include a conductive coupling portion 1450. The conductive coupling portion 1450 may further protrude from the first circuit board 1100 toward the second semiconductor device 1320. The conductive coupling portion 1450 may be referred to as a bump or, alternatively, may also be referred to as a post. The conductive coupling portion 1450 may be disposed to have a protruding structure on an electrode disposed on an uppermost side of the first circuit board 1100.

A second semiconductor device 1320 may be disposed on the conductive coupling portion 1450. In this case, the second semiconductor device 1320 may be connected to the first circuit board 1100 through the conductive coupling portion 1450. In addition, a second connection part 1420 may be disposed on the first semiconductor device 1310 and the second semiconductor device 1320.

Accordingly, the second semiconductor device 1320 may be electrically connected to the first semiconductor device 1310 through the second connection part 1420.

That is, the second semiconductor device 1320 may be connected to the first circuit board 1100 through the conductive coupling portion 1450, and may be also connected to the first semiconductor device 1310 through the second connection part 1420.

In this case, the second semiconductor device 1320 may receive a power signal and/or electric power through the conductive coupling portion 1450. Also, the second semiconductor device 1320 may transmit and receive a communication signal to and from the first semiconductor device 1310 through the second connection part 1420.

The semiconductor package according to the sixth embodiment may provide a power signal and/or electric power to the second semiconductor device 1320 through the conductive coupling portion 1450, thereby providing sufficient power for driving the second semiconductor device 1320 or enabling smooth control of a power operation.

Accordingly, the embodiment may improve the driving characteristics of the second semiconductor device 1320. That is, the embodiment may solve a problem of insufficient power provided to the second semiconductor device 1320. Furthermore, in the embodiment, at least one of a power signal, an electric power, and a communication signal of the second semiconductor device 1320 may be provided through different paths through the conductive coupling portion 1450 and the second connection part 1420. Through this, the embodiment can solve the problem that the communication signal is lost due to the power signal. For example, the embodiment may minimize mutual interference between communication signals of power signals.

Meanwhile, the second semiconductor device 1320 in the sixth embodiment may have a POP (Package On Package) structure in which a plurality of package substrates are stacked and may be disposed on the first circuit board 1100. For example, the second semiconductor device 1320 may be a memory package including a memory chip. In addition, the memory package may be coupled on the conductive coupling portion 1450. In this case, the memory package may not be connected to the first semiconductor device 1310.

Referring to FIG. 1g, the semiconductor package according to the seventh embodiment may include a first circuit board 1100, a first connection part 1410, a first connection part 1410, a semiconductor device 1300, and a third connection part 1430.

In this case, the semiconductor package of the seventh embodiment may differ from the semiconductor package of the fourth embodiment in that the first circuit board 1100 includes a plurality of substrate layers while the connection member 1110 is omitted.

The first circuit board 1100 may include a plurality of circuit board layers. For example, the first circuit board 1100 may include a first circuit board layer 1100A corresponding to a package substrate and a second circuit board layer 1100B corresponding to the connection member.

In other words, the semiconductor package of the seventh embodiment may include a first circuit board layer 1100A and a second circuit board layer 1100B in which the first circuit board (package substrate, 1100) and the second circuit board (interposer, 1200) disclosed in FIG. 1a are integrally formed. A material of the insulating layer of the second circuit board layer 1100B may be different from a material of an insulating layer of the first substrate layer 1100A. For example, the material of an insulating layer of the second circuit board layer 1100B may include a photocurable material. For example, the second circuit board layer 1100B may be a photo imageable dielectric (PID). In addition, since the second circuit board layer 1100B includes a photocurable material, it is possible to miniaturize the electrode. Accordingly, in the seventh embodiment, the second circuit board layer 1100B may be formed by sequentially stacking an insulating layer of a photo-curable material on the first circuit board layer 1100A and forming a miniaturized electrode on the insulating layer of the photo-curable material. Accordingly, the second circuit board layer 1100B may include a redistribution layer function including a micro-electrode and may include a function of horizontally connecting a plurality of semiconductor devices 1310 and 1320.

Before describing the circuit board of the embodiment, the circuit board described below may mean any one of the circuit boards included in the previous semiconductor package. For example, the circuit board described below may mean any one of the first circuit board 1100 and the second circuit board 1200 included in the semiconductor package of the first to seventh embodiments.

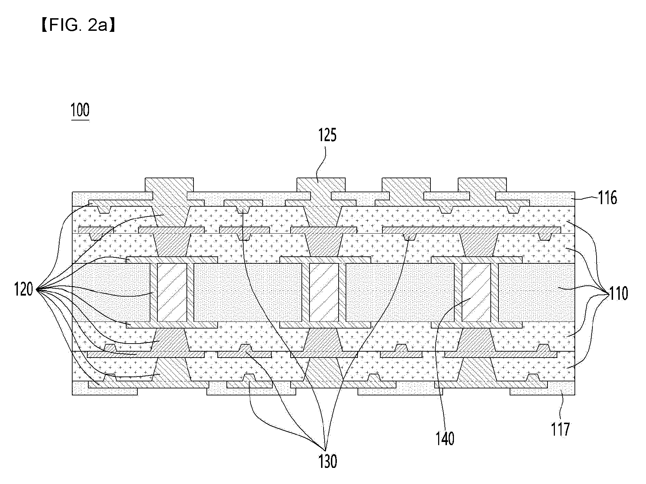

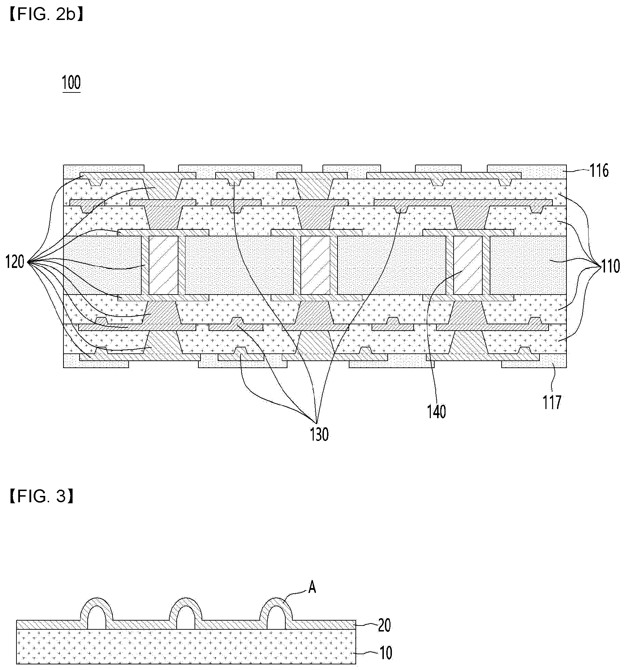

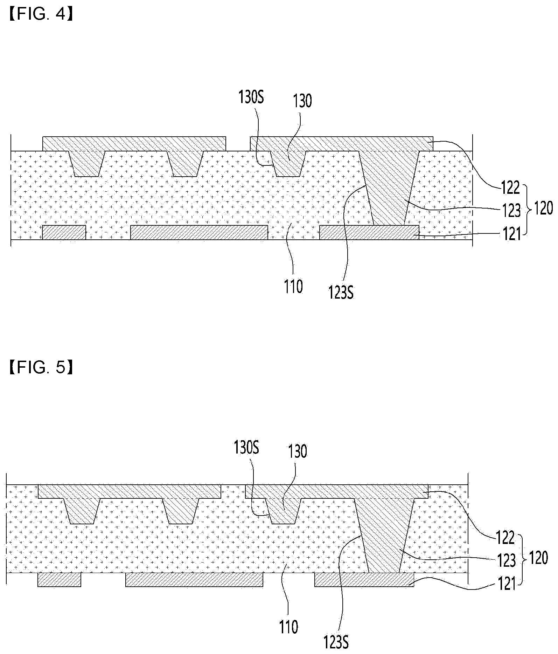

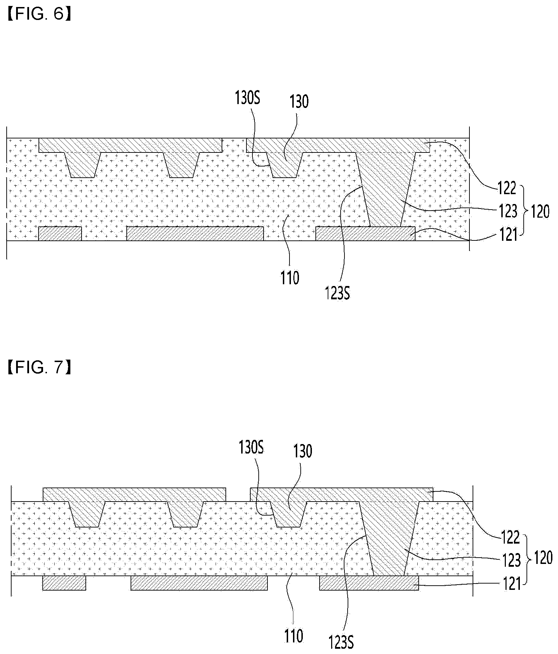

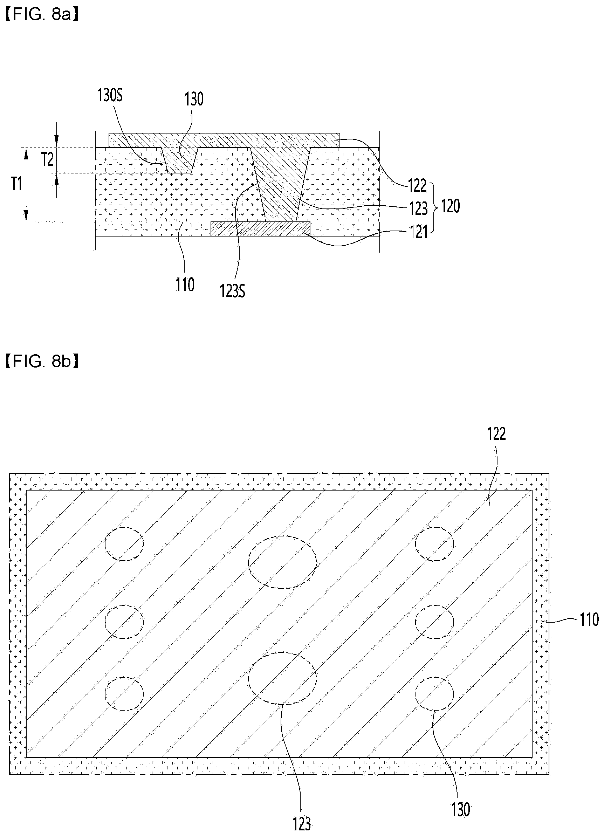

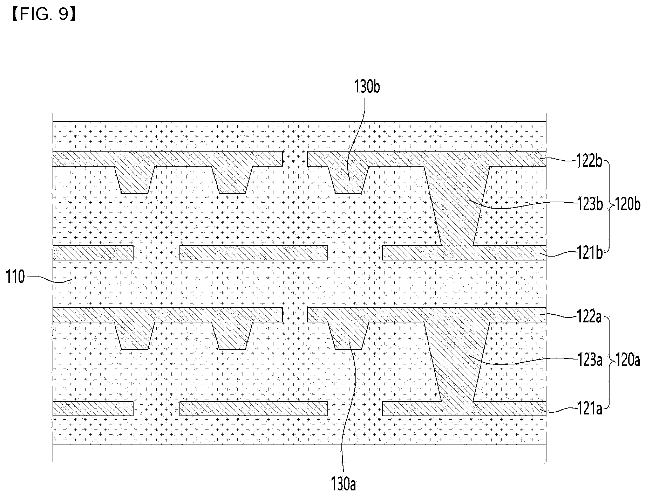

FIG. 2a is a cross-sectional view showing a circuit board according to a first embodiment, FIG. 2b is a cross-sectional view showing a circuit board according to a second embodiment, FIG. 3 is a drawing for explaining a problem of a circuit board according to a prior art, FIG. 4 is a cross-sectional view showing an arrangement structure of an electrode part according to a first embodiment, FIG. 5 is a cross-sectional view showing an arrangement structure of an electrode part according to a second embodiment, FIG. 6 is a cross-sectional view showing an arrangement structure of an electrode part according to a third embodiment, FIG. 7 is a cross-sectional view showing an arrangement structure of an electrode part according to a fourth embodiment, FIG. 8a is a plan view for explaining an arrangement structure of an electrode part according to an embodiment, FIG. 8b is a cross-sectional view for explaining an arrangement structure of an electrode part according to an embodiment, and FIG. 9 is a cross-sectional view showing an arrangement structure of an electrode part according to a fourth embodiment.

Hereinafter, a circuit board according to an embodiment will be specifically described with reference to FIGS. 2a to 9.

Referring to FIG. 2a, a circuit board 100 according to a first embodiment may include an insulating layer 110, a first resist layer 116, a second resist layer 117, an electrode part 120, and an insulating member 140. The electrode part 120 may include a second via electrode 130.

In addition, referring to FIG. 2b, a circuit board 100 according to a second embodiment may include an insulating layer 110, a first resist layer 116, a second resist layer 117, an electrode part 120, and an insulating member 140. The electrode part 120 may include a second via electrode 130 and a bonding part 125.

Specifically, FIGS. 2a and 2b can be distinguished by whether or not the bonding part 125 is included. The second via electrode 130 and the bonding part 125 are a component of the electrode part 120, and can be distinguished by a direction of protruding from one electrode constituting the electrode part 120 and/or a function. For example, the second via electrode 130 can be a part of an electrode positioned within the insulating layer 110. In addition, the bonding part 125 can be a part of an electrode not positioned within the insulating layer 110. For example, the bonding part 125 can be located outside the insulating layer 110. For example, the second via electrode 130 can be a component positioned within the insulating layer 110, and the bonding part 125 can be a component positioned outside the insulating layer 110. Hereinafter, a circuit board of an embodiment will be described with reference to FIG. 2b.

The second via electrode 130 and the bonding part 125 are a component of the electrode part 120, and can be distinguished according to the direction in which they protrude from the electrode constituting the electrode part 120 and/or their function.

The insulating layer 110 of the circuit board 100 may have a layer structure of at least one layer. Preferably, the insulating layer 110 of the circuit board 100 may have a structure in which a plurality of layers are laminated. The laminated structure may be distinguished by the electrode part 120, and may be distinguished by a difference in widths of the first electrode 121, the second electrode 122, and the first via electrode 123 of the electrode part 120.

That is, the widths of each of the first electrode 121 and the second electrode 122 of the electrode part 120 may be greater than the width of the first via electrode 123, and the laminated structure may be distinguished through this. Through the above-described laminated structure, the circuit board 100 of the embodiment may electrically efficiently connect at least one semiconductor device and/or the second circuit board to the main board.

At this time, the insulating layer 110 of the circuit board 100 in FIGS. 2a and 2b is illustrated as having a five-layer structure, but is not limited thereto. For example, the insulating layer 110 of the circuit board 100 may have four or fewer layers, or may have six or more layers. In addition, when a plurality of insulating layers 110 of the circuit board 100 include a same insulating material, it may be difficult to distinguish an interface between a plurality of insulating layers. In this case, the laminated structure can be distinguished by the first electrode 121, the second electrode 122, and the first via electrode 123 of the electrode part 120.

Meanwhile, in a case where the insulating layer 110 of the circuit board 100 has a multiple-layer structure, a plurality of first insulating layers of the circuit board 100 may include a same insulating material, but are not limited thereto. For example, at least one of the plurality of first insulating layers of the circuit board 100 may include an insulating material different from an insulating material of another first insulating layer.

The insulating layer 110 of the circuit board 100 may be rigid or flexible. For example, the insulating layer 110 of the circuit board 100 may include glass or plastic. For example, the insulating layer 110 of the circuit board 100 may include chemically strengthened/semi-strengthened glass such as soda lime glass or aluminosilicate glass. For example, the insulating layer 110 of the circuit board 100 may include a strengthened or flexible plastic such as polyimide (PI), polyethylene terephthalate (PET), propylene glycol (PPG), or polycarbonate (PC). For example, the insulating layer 110 of the circuit board 100 may include sapphire. For example, the insulating layer 110 of the circuit board 100 may include an optically isotropic film. For example, the insulating layer 110 of the circuit board 100 may include COC (Cyclic Olefin Copolymer), COP (Cyclic Olefin Polymer), optically isotropic polycarbonate (PC), or optically isotropic polymethyl methacrylate (PMMA). For example, the insulating layer 110 of the circuit board 100 may be formed of a material including an inorganic filler and an insulating resin. For example, the insulating layer 110 of the circuit board 100 may have a structure in which an inorganic filler of silica or alumina is disposed in a thermosetting resin or a thermoplastic resin.

The insulating layer 110 may have a structure in which a plurality of different insulating materials are laminated, and an exemplary arrangement structure will be described in more detail as follows.

In one embodiment, the insulating layer may include a first layer corresponding to a core layer including a reinforcing member. Here, the core layer may mean an insulating layer including a reinforcing member and having a thickness in the vertical direction thereof exceeding 100 µm. In addition, the insulating layer may include a plurality of second layers that are respectively disposed on upper and lower portions of the core layer and do not include a reinforcing member. In this case, the circuit board 100 may be a core substrate. The reinforcing member may also be referred to as a reinforcing fiber or a glass fiber.

The reinforcing member may mean a glass fiber material extending along a horizontal direction of the insulating layer, and may have a different meaning from an inorganic filler that is spaced apart from each other. That is, the reinforcing member of the first layer may have a different length or width along the horizontal direction from the filler of the second layer. For example, the glass fiber may be extended to have a width greater than the width of the first layer. Here, the meaning of having a width greater than the width of the first layer may mean that the glass fibers can be disposed in a shape that is bent in the horizontal direction. In addition, even if the second layer includes a filler, an effect of preventing problems such as bending is not as great as that of the glass fibers of the first layer, so the reinforcing member is described separately from the filler of the second layer.

In another embodiment, the insulating layer 110 of the circuit board 100 may be a coreless substrate that does not include a core. For example, the insulating layer 110 of the circuit board 100 may include an organic material that does not include a reinforcing member that has excellent processability, enables slimming of the circuit board 100, and enables miniaturization of the electrode part 120 of the circuit board 100. For example, the insulating layer 110 of the circuit board 100 may use ABF (Ajinomoto Build-up Film), a product released by Ajinomoto Co., Ltd., as an example, and the insulating layer 110 of the circuit board 100 may use FR-4, BT (Bismaleimide Triazine), PID (Photo Imageable Dielectric resin), BT, etc. For example, the insulating layer 110 may include a plurality of layers composed of ABF.

At this time, if the insulating layer 110 of the circuit board 100 is composed of only ABF that does not include a reinforcing member, the warpage characteristics of the circuit board 100 may be deteriorated. Therefore, if the insulating layer 110 of the circuit board 100 is composed of ABF (Ajinomoto Build-up Film), at least one ABF among the ABFs constituting the plurality of insulating layers of the circuit board 100 may include a reinforcing member that can improve the warpage characteristics.

For example, the insulating layer 110 of the circuit board 100 may include a first layer composed of a first ABF including a resin and a filler. In addition, the insulating layer 110 of the circuit board 100 may include a layer composed of a second ABF further including a reinforcing member in the first ABF. At this time, the reinforcing member included in the second ABF may include a GCP (Glass Core Primer) material, but is not limited thereto.

Furthermore, the insulating layer 110 may be provided with a PID that is advantageous in miniaturizing the width and/or pitch of the electrodes. The PID can form electrodes on the insulating layer 110 using an exposure and development process, thereby minimizing the width and/or pitch of the electrodes. When the insulating layer 110 is provided with a PID, a mechanical reliability problem may occur in which the adhesion between the insulating layer 110 and the electrode is reduced. However, the embodiment improves the adhesion between the insulating layer and the electrode by using a protrusion provided on the electrode described below, thereby improving the electrical reliability and/or the mechanical reliability.

A layer of the insulating layer 110 of the circuit board 100 that does not include the reinforcing member can have a thickness in a range of 10 µm to 40 µm. Preferably, the layer of the insulating layer 110 of the circuit board 100 that does not include the reinforcing member can satisfy a thickness in a range of 15 µm to 35 µm. More preferably, the layer of the insulating layer 110 of the circuit board 100 that does not include the reinforcing member can satisfy a thickness in a range of 18 µm to 32 µm. If the thickness of the layer of the insulating layer 110 of the circuit board 100 that does not include the reinforcing member is less than 10 µm, the warpage characteristics of the circuit board 100 may deteriorate. In addition, if the thickness of the layer of the insulating layer 110 of the circuit board 100 that does not include the reinforcing member is less than 10 µm, the electrode part 120 of the circuit board 100 is not stably protected, and thus the electrical reliability may be reduced. In addition, if the thickness of the layer of the insulating layer 110 of the circuit board 100 that does not include the reinforcing member exceeds 40 µm, an overall thickness of the circuit board 100 increases, and accordingly, a thickness of the semiconductor package may increase. In addition, if the thickness of the layer of the insulating layer 110 of the circuit board 100 that does not include the reinforcing member exceeds 40 µm, it may be difficult to miniaturize the electrode part 120 of the circuit board 100.

The thickness may correspond to a vertical distance between electrode parts disposed on different layers. That is, the thickness may mean a length in a direction from the upper surface to the lower surface of the circuit board 100, or from the lower surface to the upper surface, and may mean a length in a vertical direction. Here, the upper surface may mean a highest position along the vertical direction in each component, and the lower surface may mean a lowest position along the vertical direction in each component. In addition, positions of the upper surface and the lower surface may be referred to as opposite to each other.

Meanwhile, the semiconductor package of the embodiment may include a first resist layer 116 disposed on an upper surface of the circuit board 100. In addition, the semiconductor package may include a second resist layer 117 disposed on a lower surface of the circuit board 100. The first resist layer 116 and the second resist layer 117 may mean 'insulating layers' other than the insulating layer 110 of the circuit board 100. In this case, the insulating layer 110 may be referred to as a 'first insulating layer', the first resist layer 116 may be referred to as a 'second insulating layer', and the second resist layer 117 may be referred to as a 'third insulating layer'. Therefore, the insulating layer of the circuit board 100 may include not only the insulating layer 110, but also the first resist layer 116 and the second resist layer 117.

At this time, the upper surface of the circuit board 100 may mean an upper surface of the insulating layer 110, and more specifically, the upper surface of the circuit board 100 may mean an upper surface of a first insulating layer disposed at an uppermost side among the plurality of first insulating layers. The lower surface of the circuit board 100 may refer to the lower surface of the insulating layer 110, and more specifically, the lower surface of the circuit board 100 may refer to a lower surface of the first insulating layer disposed at a lowest side among the plurality of first insulating layers.

The resist layer 116 and the second resist layer 117 may have a function of protecting the upper surface and the lower surface of the circuit board 100. Accordingly, the resist layer 116 and the second resist layer 117 may be functionally referred to as a first protective layer and a second protective layer, respectively.

The resist layer 116 and the second resist layer 117 may be solder resist layers including an organic polymer material. For example, the resist layer 116 and the second resist layer 117 may include an epoxy acrylate series resin. In detail, the resist layer 116 and the second resist layer 117 may include a resin, a curing agent, a photoinitiator, a pigment, a solvent, a filler, an additive, an acrylic series monomer, etc. However, the embodiment is not limited thereto, and the resist layer 116 and the second resist layer 117 may be any one of a photo solder resist layer, a cover-lay, and a polymer material.

For example, when a bonding part 125 and the semiconductor device are bonded through solder, the solder and the solder resist layer do not have good wettability with each other, and thus, the solder can prevent a problem of electrical short-circuiting occurring between two adjacent bonding parts among the plurality of bonding parts 123. At this time, the bonding part 125 may be configured to be connected to a terminal of a semiconductor device or an electrode of an interposer with a connection part such as solder therebetween. In addition, the bonding part 125 may mean a configuration that is distinct from the second via electrode 130 described below.

A thickness of each of the resist layer 116 and the second resist layer 117 may be 1 µm to 20 µm. The thickness of each of the resist layer 116 and the second resist layer 117 may be 1 µm to 15 µm. For example, the thickness of each of the resist layer 116 and the second resist layer 117 may be 5 µm to 20 µm. In this case, the thickness of the resist layer 116 may mean a vertical distance from an upper surface of the electrode part 120 disposed at an uppermost side to an upper surface of a second insulating layer 150. In addition, the thickness of the second resist layer 117 may mean a vertical distance from a lower surface of an electrode part disposed at a lowermost side to a lower surface of the second resist layer 117.

If the thickness of each of the resist layer 116 and the second resist layer 117 exceeds 20 µm, it may be difficult to thin the semiconductor package due to an increase in the thickness of the semiconductor package, or stress applied to the insulating layer disposed between the resist layer 116 and the second resist layer 117 may increase. If the thickness of each of the resist layer 116 and the second resist layer 117 is less than 1 µm, it may be difficult to stably protect the electrode part 120 included in the circuit board 100, and thus the electrical reliability or physical reliability may be deteriorated.

The circuit board 100 may include an electrode part 120. The electrode part 120 may be disposed on an insulating layer 110 of the circuit board 100. For example, the electrode part 120 may be disposed in the insulating layer of the circuit board 100. At this time, being disposed in the insulating layer may mean that the electrode part 120 is disposed within an insulating layer including an insulating layer 110, a first resist layer 116, and a second resist layer 117.

The electrode part 120 may include a plurality of electrodes depending on a position or a function.

For example, the electrode part 120 may include a first electrode 121 and a second electrode 122 disposed on the first electrode 121. In addition, the electrode part 120 may include a first via electrode 123 connecting the first electrode 121 and the second electrode 122 along the vertical direction of the circuit board 100. That is, the first via electrode 123 may be disposed between the first electrode 121 and the second electrode 122, and thus, the first electrode 121 and the second electrode 122 may be electrically connected.

At this time, when the insulating layer 110 of the circuit board 100 has a five-layer structure, the first via electrode 123 of the electrode part 120 may have a five-layer structure along the vertical direction. In addition, the first electrode 121 or the second electrode 122 may be disposed between the five layers of the first via electrode 123.

At this time, at least one of the first electrode 121 and the second electrode 122 of the electrode part 120 may have an ETS (Embedded Trace Substrate) structure. For example, the first electrode 121 of the electrode part 120 disposed at an uppermost side of the circuit board 100 may have an ETS structure. For example, the first electrode 121 of the electrode part 120 disposed at the uppermost side of the circuit board 100 may be disposed in a recess provided at an upper surface of an uppermost insulating layer. The ETS structure may also be referred to as am embedded structure. The ETS structure is advantageous for miniaturization compared to an electrode part having a general protruding structure. Accordingly, the embodiment enables the formation of electrodes corresponding to the size and pitch of terminals provided in the semiconductor device. Through this, the embodiment can improve the circuit integration. Furthermore, the embodiment can minimize a transmission distance of a signal transmitted through the semiconductor device, thereby minimizing signal transmission loss.

At this time, the first electrode 121 and the second electrode 122 of the electrode part 120 may be referred to as opposite to each other. For example, the first electrode 121 of the electrode part 120 may refer to the second electrode 122 depending on a position of the first via electrode 123 that serves as a reference. In addition, the second electrode 122 of the electrode part 120 may refer to the first electrode 121 depending on a position of the first via electrode 123 that serves as a reference.

For example, the first via electrode 123 may include a third-first electrode disposed in a first layer of the insulating layer 110, a third-second electrode disposed in a second layer on the first layer, and a third-third electrode disposed in a third layer on the second layer.

At this time, an electrode disposed between the third-first electrode and the third-second electrode can be a 'second electrode' based on the third-first electrode, and can be a 'first electrode' based on the third-second electrode.

In addition, an electrode disposed between the third-second electrode and the third-third electrode can be a 'second electrode' based on the third-second electrode, and can be a 'first electrode' based on the third-third electrode.

The first electrode 121 and the second electrode 122 can perform a function of transmitting a signal in a horizontal direction on the insulating layer 110. In addition, the first via electrode 123 is connected to the first electrode 121 and the second electrode 122, and can perform a function of transmitting a signal between the first electrode 121 and the second electrode 122 in a vertical direction. The first via electrode 123 can also be referred to a through electrode or a via.

Meanwhile, the electrode part 120 can include a second via electrode 130. Preferably, the second electrode 122 of the electrode part 120 may include a second via electrode 130. At this time, although the second via electrode 130 is described as being a configuration included in the second electrode 122, the embodiment is not limited thereto. That is, as described, the second electrode 122 may be the first electrode 121 according to the first via electrode 123 that serves as a reference. Accordingly, the second via electrode 130 may be a configuration provided in the first electrode 121.

Hereinafter, for convenience of explanation, it will be described that the second via electrode 130 is a configuration of the second electrode 122 of the electrode part 120.

The second via electrode 130 may extend in a vertical direction from the second electrode 122 of the electrode part 120. The second via electrode 130 may be disposed between the first electrode 121 and the second electrode 122. The second via electrode 130 may be disposed between the first electrode 121 and the second electrode 122 and spaced apart from the first via electrode 123 in the horizontal direction.

The first via electrode 123 may extend in a vertical direction from the second electrode 122. At this time, a length of the second via electrode 130 in the vertical direction may be different from a length of the first via electrode 123 in the vertical direction.

That is, the first via electrode 123 may function to electrically connect the first electrode 121 and the second electrode 122.

Accordingly, the first via electrode 123 may be connected to the first electrode 121 and the second electrode 122. The first via electrode 123 can electrically connect the first electrode 121 and the second electrode 122. In contrast, the second via electrode 123 may not electrically connect the first electrode 121 and the second electrode 122. For example, the second via electrode 123 may be connected to one of the first electrode 121 and the second electrode 122 and may not be connected to another electrode.

Therefore, a length of the first via electrode 123 in a vertical direction may correspond to a distance between the first electrode 121 and the second electrode 122 in a vertical direction.

In contrast, the second via electrode 130 may function to improve the adhesion between the second electrode 122 and the insulating layer 110.

That is, the second via electrode 130 increases an contact area between the insulating layer 110 and the electrode part 120, thereby solving a problem of the electrode part 120 being peeled off from the insulating layer 110. In addition, the second via electrode 130 can prevent the circuit board 100 from being greatly bent in a specific direction.

Specifically, as the number of input terminals and output terminals of the semiconductor device increases, the width and/or spacing of the terminals of the semiconductor device and/or the semiconductor chiplet is narrowing. Accordingly, the width and/or spacing of the electrodes provided on the circuit board are also becoming smaller. In addition, as the width and/or spacing of the electrodes become smaller, the contact area between the electrode part 120 and the insulating layer 110 decreases, which may cause a mechanical reliability problem in which the electrode part 120 is easily peeled off from the insulating layer 110. Furthermore, in order to minimize the width and/or spacing of the electrodes, the insulating layer may include a photosensitive material. The photosensitive material may be, for example, a PID (Photo Imageable Dielectric). The insulating layer having a photosensitive material can be shaped into an electrode using a photolithography process, and thus it may be advantageous to refine the width and/or spacing of the electrode. At this time, the photosensitive material has a characteristic of having low adhesion to the electrode compared to a thermosetting material. Accordingly, when the width and/or spacing of the electrode is refined or the insulating layer includes the photosensitive material, the embodiment can solve the mechanical reliability problem of electrodes peeling off from the insulating layer, thereby improving the overall product reliability of circuit boards and semiconductor packages.

In addition, the rigidity of the insulating layer provided with the photosensitive material may be lower than the rigidity of the thermosetting material provided with the reinforcing member. Accordingly, the circuit board provided with the photosensitive material has a problem of being greatly bent in a specific direction. At this time, the embodiment can improve the rigidity of the circuit board by using the protrusion provided in the electrode, and thus prevent the circuit board and the semiconductor package from being greatly bent in a specific direction.

In addition, the second via electrode 130 can solve a problem of the electrode part 120 being peeled off from the insulating layer 110 by the gas generated in the insulating layer 110. For example, to briefly explain a manufacturing process of the circuit board 100, the insulating layer 110 can be provided in a semi-cured state. Then, the electrode part 120 can be disposed on the insulating layer 110 having the semi-cured state. Then, a process of completely curing the insulating layer 110 can be performed after the electrode part 120 is disposed.

At this time, when the process of completely curing the insulating layer 110 is performed, gas may be generated from the insulating layer 110. At this time, the generated gas must be discharged from the insulating layer 110 to an outside of the circuit board 100. At this time, the electrode part 120 is disposed on the insulating layer 110. Accordingly, the gas generated from the insulating layer 110 may not be discharged to the outside of the circuit board 100 by the electrode part 120 and may remain within the insulating layer 110.

Therefore, the electrode part 120 of the embodiment may include a second via electrode 130. In addition, the second via electrode 130 increases the adhesion between the electrode part 120 and the insulating layer 110, and thus prevents the electrode part 120 from being peeled off from the insulating layer 110 by the generated gas.

For example, if the second via electrode 130 is not provided in the electrode part 120, a problem may occur in which the electrode part 120 swells above the insulating layer 110 due to gas generated from the insulating layer 110.

For example, referring to FIG. 3, an electrode part of the circuit board of a comparative example may not be provided with the second via electrode. In addition, the electrode part of the comparative example may not be provided with a through hole for gas discharge for various reasons described above. Accordingly, the circuit board of the comparative example may have a problem in which gas generated from the insulating layer 10 is not discharged to an upper side of the electrode part 20. Accordingly, the circuit board of the comparative example may have a problem in which the electrode part 20 swells due to gas. For example, the electrode part 20 of the comparative example may include a convex region (A) that swells upward from the insulating layer 10. The electrode part 120 may not be in contact with the insulating layer 10 in the convex region (A). Accordingly, the circuit board of the comparative example may have a physical reliability problem in which the adhesion between the electrode part 20 and the insulating layer 10 is reduced due to the convex region (A), and thus the electrode part 20 may be separated from the insulating layer 10.

In contrast, the embodiment may have a second via electrode 130 provided on the second electrode 122 of the electrode part 120. In addition, the second via electrode 130 may have a function of improving the adhesion between the electrode part 120 and the insulating layer 110. For example, the second via electrode 130 may have an anchor function that firmly fixes the electrode part 120 to the insulating layer 110. Accordingly, the embodiment may improve the adhesion between a plurality of insulating layers and the adhesion between the insulating layer and the electrode part. Through this, the embodiment can improve the physical reliability of the circuit board.

Meanwhile, the second via electrode 130 may be provided in a region of the second electrode 122 that should not be connected to the first electrode 121.

However, the second via electrode 130 may be provided in a region of the second electrode 122 that is electrically connected to the first electrode 121, and thus may connect the first electrode 121 and the second electrode 122. However, when the second via electrode 130 connects the first electrode 121 and the second electrode 122, the function and structure of the second via electrode may correspond to the function and structure of the first via electrode 123.

That is, the first via electrode 123 may extend in a vertical direction from the second electrode 122 together with the second via electrode 130. In addition to the function of electrically connecting the first electrode 121 and the second electrode 122, the first via electrode 123 may also have the function of improving the adhesion between the insulating layer 110 and the electrode part 120. Therefore, the first via electrode 123 may be disposed instead of the second via electrode 130 in an entire region of the insulating layer 110. However, the electrode part 120 includes a region where the first electrode 121 and the second electrode 122 should not be electrically connected to each other, and the first via electrode 123 may not be disposed in the region. Furthermore, if only the first via electrode 123 is included instead of the second via electrode 130, there is a problem that the time, cost, and material for plating the first via electrode 123 increase. In addition, as the number of first via electrodes 123 increases, a flatness of the second electrode 122 plated together with the first via electrode 123 may deteriorate. For example, the second electrode 122 may be plated together with the first via electrode 123. At this time, when a number of first via electrodes 123 increases, a step may exist between a region of the second electrode 122 that vertically overlaps with the first via electrode 123 and a region that does not vertically overlap with the first via electrode 123. In addition, the step may act as a factor that reduces the physical reliability and electrical reliability of the circuit board.

Therefore, the embodiment provides at least one second via electrode 130 on the electrode part 120.

In addition, the second electrode 122 should not be electrically connected to the first electrode 121 through the second via electrode 130. At this time, when a length of the second via electrode 130 of the second electrode 122 in the vertical direction has the same as a length of the first via electrode 123 in the vertical direction, the second via electrode 130 can be electrically connected to the first electrode 121 that overlaps in the vertical direction. Therefore, the length of the second via electrode 130 in the vertical direction can be smaller than the length of the first via electrode 123 in the vertical direction. At this time, the length in the vertical direction of the first via electrode 123 according to the arrangement structure of the first electrode 121 and the second electrode 122 will be described. That is, positions and structures of the first electrode 121, the second electrode 122, the first via electrode 123, and the second via electrode 130 of the electrode part 120 can vary based on a specific insulating layer among the insulating layers 110 of the circuit board 100.

That is, referring to FIG. 4, the first electrode 121 may be embedded in the insulating layer 110. For example, the first electrode 121 may be disposed in a recess (not shown) provided at a lower surface of the insulating layer 110. In addition, the second electrode 122 may be disposed on the insulating layer 110. For example, the second electrode 122 may protrude on an upper surface of the insulating layer 110. Meanwhile, the first via electrode 123 may be disposed in the insulating layer 110. The first via electrode 123 may be disposed between the first electrode 121 and the second electrode 122. The first via electrode 123 may extend from the first electrode 121 to the second electrode 122 in a vertical direction. In addition, the first via electrode 123 may extend from the second electrode 122 to the first electrode 121 in the vertical direction. At this time, the length of the first via electrode 123 in the vertical direction may be smaller than a length of the insulating layer 110 in the vertical direction. For example, the length of the first via electrode 123 in the vertical direction may correspond to a distance from an upper surface of the first electrode 121 to a lower surface of the second electrode 122 in the vertical direction. In addition, the second via electrode 130 may extend in the vertical direction from the second electrode 122 toward the first electrode 121. At this time, the length of the second via electrode 130 in the vertical direction may be different from the length of the first via electrode 123 in the vertical direction. Preferably, the length of the second via electrode 130 in the vertical direction may be smaller than the length of the first via electrode 123 in the vertical direction. For example, the lower surface of the second via electrode 130 may be positioned higher than the lower surface of the first via electrode 123. In addition, the upper surface of the second via electrode 130 may be positioned on a same plane as the upper surface of the first via electrode 123.

In addition, referring to FIG. 5, the first electrode 121 may be positioned under the insulating layer 110. For example, the first electrode 121 may protrude below the lower surface of the insulating layer 110. The second electrode 122 may be embedded in the insulating layer 110. For example, the second electrode 122 may be positioned in a recess (not shown) provided at the upper surface of the insulating layer 110. Meanwhile, the first via electrode 123 may be positioned in the insulating layer 110. The first via electrode 123 may be disposed between the first electrode 121 and the second electrode 122. The first via electrode 123 may extend from the first electrode 121 to the second electrode 122 in a vertical direction. In addition, the first via electrode 123 may extend from the second electrode 122 to the first electrode 121 in a vertical direction.

In addition, referring to FIG. 6, the first electrode 121 may be embedded in the insulating layer 110. For example, the first electrode 121 may be disposed in a recess (not shown) provided at the lower surface of the insulating layer 110. The second electrode 122 may be embedded in the insulating layer 110. For example, the second electrode 122 may be disposed in a recess (not shown) provided at the upper surface of the insulating layer 110. Meanwhile, the first via electrode 123 may be disposed in the insulating layer 110. The first via electrode 123 may be disposed between the first electrode 121 and the second electrode 122. The first via electrode 123 may extend from the first electrode 121 to the second electrode 122 in the vertical direction. In addition, the first via electrode 123 may extend from the second electrode 122 to the first electrode 121 in the vertical direction.

In addition, referring to FIG. 7, the first electrode 121 may be disposed under the insulating layer 110. For example, the first electrode 121 may protrude below the lower surface of the insulating layer 110. In addition, the second electrode 122 may be disposed on the insulating layer 110. For example, the second electrode 122 may protrude above the upper surface of the insulating layer 110. Meanwhile, the first via electrode 123 may be disposed in the insulating layer 110. The first via electrode 123 may be disposed between the first electrode 121 and the second electrode 122. The first via electrode 123 may extend from the first electrode 121 to the second electrode 122 in a vertical direction. In addition, the first via electrode 123 may extend from the second electrode 122 to the first electrode 121 in a vertical direction.

Meanwhile, referring to FIGS. 8a and 8b, a length T1 of the first via electrode 123 of the embodiment in the vertical direction may correspond to a distance between the first electrode 121 and the second electrode 122 in the vertical direction. At this time, in a case of FIG. 4, a length T1 of the first via electrode 123 in the vertical direction may correspond to a value obtained by subtracting a thickness of the first electrode 121 from a thickness of one insulating layer. In addition, in a case of FIG. 5, a length T1 of the first via electrode 123 in the vertical direction may correspond to a value obtained by subtracting a thickness of the second electrode 122 from a thickness of one insulating layer. In addition, in a case of FIG. 6, a length T1 of the first via electrode 123 in the vertical direction may correspond to a value obtained by subtracting a thickness of the first electrode 121 and a thickness of the second electrode 122 from a thickness of one insulating layer. In addition, in a case of FIG. 7, a length T1 of the first via electrode 123 in the vertical direction may correspond to a thickness of one insulating layer.

A length T2 of the second via electrode 130 in the vertical direction may be different from the length T1 of the first via electrode 123 in the vertical direction. Preferably, the length T2 of the second via electrode 130 in the vertical direction may be smaller than the length T1 of the first via electrode 123 in the vertical direction. For example, the length T2 of the second via electrode 130 in the vertical direction may satisfy a range of 30% to 70% of the length T1 of the first via electrode 123 in the vertical direction. Preferably, the length T2 of the second via electrode 130 in the vertical direction may satisfy a range of 35% to 65% of the length T1 of the first via electrode 123 in the vertical direction. More preferably, the length T2 of the second via electrode 130 in the vertical direction may satisfy a range of 40% to 60% of the length T1 of the first via electrode 123 in the vertical direction.

If the length T2 of the second via electrode 130 in the vertical direction is less than 30% of the length T1 of the first via electrode 123 in the vertical direction, an effect of increasing the adhesion between the insulating layer 110 and the electrode part 120 achieved by the second via electrode 130 may be insufficient. As a result, a physical reliability problem in which the electrode part 120 is peeled off from the insulating layer 110 may occur. If the length T2 of the second via electrode 130 in the vertical direction exceeds 70% of the length T1 of the first via electrode 123 in the vertical direction, the second via electrode 130 and the first electrode 121 may be electrically connected due to process errors, which may cause a circuit short-circuit problem. If the length T2 of the second via electrode 130 in the vertical direction exceeds 70% of the length T1 of the first via electrode 123 in the vertical direction, time, materials, and costs for forming the second via electrode 130 may be wasted. If the length T2 of the second via electrode 130 in the vertical direction exceeds 70% of the length T1 of the first via electrode 123 in the vertical direction, a flatness of the second electrode 122 may deteriorate.

Meanwhile, a width of the second via electrode 130 may be different from a width of the first via electrode 123. Preferably, the width of the second via electrode 130 may be smaller than the width of the first via electrode 123.

For example, the second via electrode 130 may have a slope 130S whose width gradually decreases from a region adjacent to the second electrode 122 toward the first electrode 121.

In addition, the first via electrode 123 may have a slope 123S whose width gradually decreases from a region adjacent to the second electrode 122 toward the first electrode 121.

At this time, the slope 130S of the second via electrode 130 may correspond to the slope 123S of the first via electrode 123.

For example, the second via electrode 130 may be formed by filling a recess provided in the insulating layer 110. In addition, the first via electrode 123 may be formed by filling a through hole passing through the insulating layer 110. At this time, a recess filled by the second via electrode 130 may be formed in a same process or a same equipment as the through hole filled by the first via electrode 123. For example, the recess may be formed together with the through hole when the through hole is formed. For example, the recess may be formed using equipment used to form the through hole. Accordingly, the slope 123S of the first via electrode 123 may correspond to the slope 130S of the second via electrode 130.

In addition, a width of a region with a greatest width among the entire regions of the second via electrode 130 may be smaller than a width of a region with a greatest width among the entire regions of the first via electrode 123. Through this, the embodiment may increase the adhesion between the electrode part 120 and the insulating layer 110 by the second via electrode 130 without changing the electrical characteristics of the second electrode 122.

Meanwhile, referring to FIG. 9, although the insulating layer 110 is composed of multiple layers, it may be difficult to distinguish an interface between these layers.

Accordingly, a plurality of electrode parts may be provided in the insulating layer 110 where the interface is not distinguished.

For example, a first electrode part 120a and a second electrode part 120b may be provided in the vertical direction in the insulating layer 110.

The second electrode part 120b may be disposed on the first electrode part 120a within the insulating layer 110.

In addition, the first electrode part 120a may include a first electrode 121a, a second electrode 122a, a first via electrode 123a, and a second via electrode 130a, respectively.

In addition, the second electrode part 120b may include a first electrode 121b, a second electrode 122b, a first via electrode 123b, and a second via electrode 130b, respectively.

Accordingly, the first electrode, the second electrode, the first via electrode, and the second via electrode of the electrode part may all be provided within the insulating layer.

Meanwhile, the electrode part 120 may include a bonding part 125. The bonding part 125 may protrude on the circuit board 100 in a direction away from the circuit board 100. The bonding part 125 may be provided on the second electrode 122 disposed at an uppermost side among the electrode parts 120. However, the embodiment is not limited thereto. The bonding part 125 may also be provided under the first electrode 121 disposed at a lowermost side among the electrode parts 120.

Accordingly, the second electrode 122 of the electrode part 120 disposed at the uppermost side of the circuit board 100 may be provided with a second via electrode 130 extending in a vertical direction toward the inside of the insulating layer 110 and a bonding part 125 extending in a vertical direction toward the outside of the insulating layer 110.

The bonding part 125 may be referred to as a bump. The bonding part 125 may also be referred to as a post. The bonding part 125 may be referred to as a pillar. A semiconductor device may be disposed on the electrode part 120 of the circuit board 100. In contrast, an interposer coupled with a semiconductor device may be coupled on the electrode part 120 of the circuit board 100. At this time, as the pitch of the terminal of the semiconductor device or the electrode of the interposer becomes fine, a problem of short-circuiting of conductive connection parts disposed on a plurality of terminals or electrodes may occur. Accordingly, in order to reduce a volume of the conductive connection part disposed on each of the plurality of terminals or electrodes, the electrode part 120 may include a protrusion 125. In addition, when using the thermal compression bonding that applies heat and pressure to the conductive connection part disposed between the circuit board 100 and the semiconductor device or the interposer to bond them, the bonding part 125 may have a function of improving the alignment between the electrode part 120 and the terminal of the semiconductor device or the electrode of the interposer. Furthermore, the bonding part 125 may have a function of preventing diffusion of the conductive connection part.

The electrode part 120 may be formed of at least one metal material selected from gold (Au), silver (Ag), platinum (Pt), titanium (Ti), tin (Sn), copper (Cu), and zinc (Zn). In addition, the electrode part 120 of the circuit board 100 may be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the electrode part 120 of the circuit board 100 may be formed of copper (Cu) having high electrical conductivity and relatively low price.

Each of the first electrode 121 and the second electrode 122 of the electrode part 120 may have a thickness in a range of 7 µm to 20 µm. For example, each of the first electrode 121 and the second electrode 122 of the electrode part 120 may have a thickness in a range of 9 µm to 17 µm. Each of the first electrode 121 and the second electrode 122 of the electrode part 120 may have a thickness in a range of 10 µm to 13 µm. If the thickness of each of the first electrode 121 and the second electrode 122 of the electrode part 120 is less than 7 µm, a resistance of the electrode part 120 may increase and an allowable current of a transmittable signal may decrease. In addition, if the thickness of each of the first electrode 121 and the second electrode 122 of the electrode part 120 exceeds 20 µm, it may be difficult to miniaturize the electrode part 120 and to thin the circuit board 100.

Meanwhile, if the electrode part 120 includes a bonding part 125, a width of the bonding part 125 may have a range of 40 µm to 70 µm. If the width of the bonding part 125 is smaller than 40µm, since the width of the bonding part 125 is too small, a problem of collapse may occur during thermal compression bonding. In addition, if the width of the bonding part 125 is greater than 70µm, it may have a problem in that it is difficult to correspond to the fine pitch of the terminal of the semiconductor device or the electrode of the interposer.

Meanwhile, the first via electrode 123 of the electrode part 120 can be formed by filling the inside of the through hole provided in the insulating layer 110 with a conductive material. The through hole can be formed by any one of mechanical, laser, and chemical processing methods. When the through hole is formed by mechanical processing, methods such as milling, drilling, and routing can be used. In addition, when the through hole is formed by laser processing, a UV or CO₂ laser method can be used. In addition, when the through hole is formed by chemical processing, a chemical containing aminosilane, ketones, etc. can be used. In addition, the through hole corresponding to the first via electrode 123 can be formed together with a recess corresponding to the second via electrode 130, but is not limited thereto.

Meanwhile, when the through hole and recess are formed, the inside of the through hole and recess can be filled with a conductive material to form the first via electrode 123 and the second via electrode 130 of the circuit board 100.

Meanwhile, when the insulating layer 110 includes a core layer, an insulating member 140 can be provided in the core layer. The insulating member 140 can be provided to fill a part of the through hole penetrating the core layer. The insulating member 140 can also be called a hole plugging member. The insulating member 140 can include an insulating material provided in the through hole of the core layer. For example, the insulating member 140 can include a paste of an insulating ink material. For example, the insulating member 140 can include a plugging ink. However, the embodiment is not limited thereto. For example, the insulating member 140 can include a conductive material. Specifically, the insulating member 140 may include a conductive paste containing conductive metal powder.

On the other hand, when the circuit board having the above-described characteristics of the invention is used in an IT device or home appliance such as a smart phone, a server computer, a TV, and the like, functions such as signal transmission or power supply can be stably performed. For example, when a circuit board having the features of the present invention performs a semiconductor package function, the circuit board can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
an insulating layer; and,
an electrode part disposed in the insulating layer,
wherein the electrode part includes:
a first electrode;
a second electrode disposed on the first electrode; and
first and second via electrodes disposed between the first electrode and the second electrode,
wherein the first via electrode is connected to the first electrode and the second electrode, and
wherein a length of the second via electrode in a vertical direction is smaller than a length of the first via electrode in the vertical direction.

2. The circuit board of claim 1, wherein the second via electrode is connected to the second electrode.

3. The circuit board of claim 1, wherein the second via electrode is spaced apart from the first via electrode in a horizontal direction.

4. The circuit board of claim 1, wherein the second via electrode extends from the second electrode toward the first electrode.

5. The circuit board of claim 1, wherein an upper surface of the second via electrode is positioned on a same plane as an upper surface of the first via electrode, and
wherein a lower surface of the second via electrode is positioned higher than a lower surface of the first via electrode.

6. The circuit board of claim 1, wherein the length of the second via electrode in the vertical direction satisfies a range of 30% to 70% of the length of the first via electrode in the vertical direction.

7. The circuit board of claim 1, wherein a width of the second via electrode in a horizontal direction is smaller than a width of the first via electrode in the horizontal direction.

8. The circuit board of any one of claims 1 to 7, wherein the second via electrode has a slope whose width in the horizontal direction gradually changes as the second via electrode moves away from the second electrode.

9. The circuit board of claim 8, wherein the first via electrode has a slope whose width in the horizontal direction gradually changes from the second electrode toward the first electrode.

10. The circuit board of claim 9, wherein the slope of the second via electrode is same as the slope of the first via electrode.
